# EUROPEAN PATENT APPLICATION

(11) **EP 3 048 638 A1**
(43) Date of publication of application: **27.07.2016**
(21) Application number: 14846557.8
(22) Date of filing: 02.09.2014
(51) Int. Cl.: H01L 21/3065, B82Y 40/00

(54) **ETCHING METHOD**

(30) Priority: 19.09.2013 JP 2013194285; 05.02.2014 JP 2014020628
(71) Applicant: Tokyo Electron Limited, Tokyo 107-6325 (JP)
(72) Inventor: TOBANA, Toshikatsu, Kurokawa-gun Miyagi 981-3629 (JP); YAMASHITA, Fumiko, Kurokawa-gun Miyagi 981-3629 (JP)
(74) Representative: Hoffmann Eitle
(86) International application number: PCT/JP2014/073042
(87) International publication number: WO 2015/041043

(57) **Abstract**

Provided is a method for etching a layer to be etched on an object to be processed. Said method involves: a step (a) for forming a self-organizing block copolymer layer, which contains a first polymer and a second polymer, on a middle layer disposed on a layer to be etched; a step (b) for processing the object to be processed so that a first region containing the first polymer and a second region containing the second polymer are formed from the block copolymer layer; a step (c) for forming a mask by etching the second region and the middle layer that is directly below the second region after step (b) for processing the object to be processed; a step (d) for forming a protective film on the mask by generating plasma of a treatment gas containing oxygen gas and silicon tetrachloride gas within a treatment container of a plasma treatment device housing the object to be processed after the step (c) for forming a mask; and a step (e) for etching the layer to be etched after the step (d) for forming a protective film.

## Description

### Technical Field

An exemplary embodiment of the present disclosure relates to an etching method.

### Background

In order to realize further miniaturization of a device such as, for example, a semiconductor device, it is necessary to form a pattern with a dimension smaller than the critical dimension obtained by a fine processing using a photolithography technique so far achieved. As a method of forming a pattern with such a dimension, development of extreme ultraviolet (EUV), which is a next-generation exposure technique, is promoted. In the EUV, a light having a remarkably short wavelength (*e.g*., 13.5 nm) is used, as compared with a wavelength of a conventional UV light source. Therefore, in the EUV, there is a technical barrier against mass production. For example, the EUV has a problem such as a long exposure time. Thus, what is demanded is to develop an alternative manufacturing method which can provide a further miniaturized device.

As an alternative to the conventional lithography technique, attention has been paid to a technique of forming a pattern using a self-assembled block copolymer (BCP) which is one of self-assembled materials that spontaneously assemble an order pattern. Such a technique is described in Patent Documents 1 and 2.

In the technique described in Patent Document 1, a block copolymer layer is coated on a base layer. The block copolymer layer contains a block copolymer containing two or more polymer block components A and B which are immiscible with each other. Then, a heat treatment (annealing) is performed to cause the polymer block components A and B to spontaneously phase-separate from each other. Thus, an ordered pattern having a first region containing the polymer block component A and a second region containing the polymer block component B, is obtained. Further, in Patent Document 2, a patterning processing of block copolymers has been suggested as a method of forming a via. In the patterning processing described in Patent Document 2, a pattern is obtained by removing the second region among the first region and the second region of the phase-separated block copolymer layer.

### Prior Art Document

### Patent Document

Patent Document 1: Japanese Patent Laid-Open Publication No. 2007-208255
Patent Document 2: Japanese Patent Laid-Open Publication No. 2010-269304

### Disclosure of the Invention

### Problems to be Solved

In the techniques described in Patent Documents 1 and 2, when an etching target layer is etched using a mask obtained by the patterning of the block copolymer, the pattern of the mask may be deformed.

Accordingly, it is required to suppress the mask obtained by the patterning of the block copolymer from being deformed due to the etching of the etching target layer.

### Means to Solve the Problems

According to an aspect, provided is a method of etching an etching target layer of a workpiece. The method includes a step (a) of forming a self-assemblable block copolymer layer containing a first polymer and a second polymer on an intermediate layer formed on the etching target layer; a step (b) of processing the workpiece to form a first region containing the first polymer and a second region containing the second polymer, from the block copolymer layer; after the step (b), a step (c) of forming a mask by etching the second region and the intermediate layer just below the second region; after the step (c), a step (d) of forming a protective film on the mask by generating plasma of a processing gas containing silicon tetrachloride gas and oxygen gas within a processing container of a plasma processing apparatus that accommodates the workpiece; and after the step (d), a step (e) of etching the etching target layer.

In the method according to the above-described aspect, a protective film is formed on the mask. The protective film contains silicon oxide based on oxygen and silicon in the plasma generated in the step (d). Owing to the protective film, the mask is protected from the etching in the step (e). Accordingly, it is possible to suppress the mask from being deformed due to the etching of the etching target layer.

In an exemplary embodiment, the etching target layer is a silicon-containing layer. In the step (e), plasma of a processing gas containing at least one of fluorocarbon gas and fluorohydrocarbon gas may be generated within the processing container. According to the exemplary embodiment, it is possible to etch the etching target layer by active species of fluorine. In addition, it is also possible to remove the protective film deposited by the step (d), on the surface of the etching target layer exposed from the mask.

In another aspect, provided is another method of etching an etching target layer of a workpiece. The method includes a step (a) of forming a self-assemblable block copolymer layer containing a first polymer and a second polymer on an intermediate layer formed on the etching target layer; a step (b) of processing the workpiece to form a first region containing the first polymer and a second region containing the second polymer, from the block copolymer layer; after the step (b), a step (c) of forming a mask by etching the second region and the intermediate layer just below the second region; after the forming the mask, a step (f) of etching the etching target layer. The etching target layer, which is a subject to be etched in this method, is a layer containing silicon oxide or silicon nitride. In the step (f), plasma of a processing gas containing at least one of fluorocarbon gas and fluorohydrocarbon gas, and hydrogen bromide gas, is generated within the processing container.

In the method according to the above-described aspect, a protective layer is formed, which contains components such as SiBrO derived from active species of atoms or molecules contained in hydrogen bromide gas contained in the gas used in the step (f). Further, the mask is modified, that is, cured by the active species of Br. As a result, it is possible to suppress the mask from being deformed due to the etching of the etching target layer.

In an exemplary embodiment of the above-described method, the first polymer may be polystyrene, and the second polymer may be poly(methyl methacrylate).

### Effect of the Invention

As described above, according to the aspects and various exemplary embodiments, the mask obtained by the patterning of the block copolymer may be suppressed from being deformed due to the etching of the etching target layer.

### Brief Description of the Drawings

FIG. 1 is a flowchart illustrating an etching method according to an exemplary embodiment.
FIG 2 is a view illustrating a cross-section of a product prepared in each step illustrated in FIG. 1.
FIG. 3 is a view illustrating a cross-section of a product prepared in each step illustrated in FIG. 1.
FIG. 4 is a view illustrating a cross-section of a product prepared in each step illustrated in FIG. 1.
FIG. 5 is a view for explaining self-assembling of a block copolymer.
FIG. 6 is a view schematically illustrating an exemplary embodiment of a plasma processing apparatus.
FIG. 7 is a flowchart illustrating an etching method according to another exemplary embodiment.

### Detailed Description to Execute the Invention

Hereinafter, an exemplary embodiment of the present disclosure will be described with reference to drawings. Same or corresponding portions in the drawings will be denoted by the same symbols.

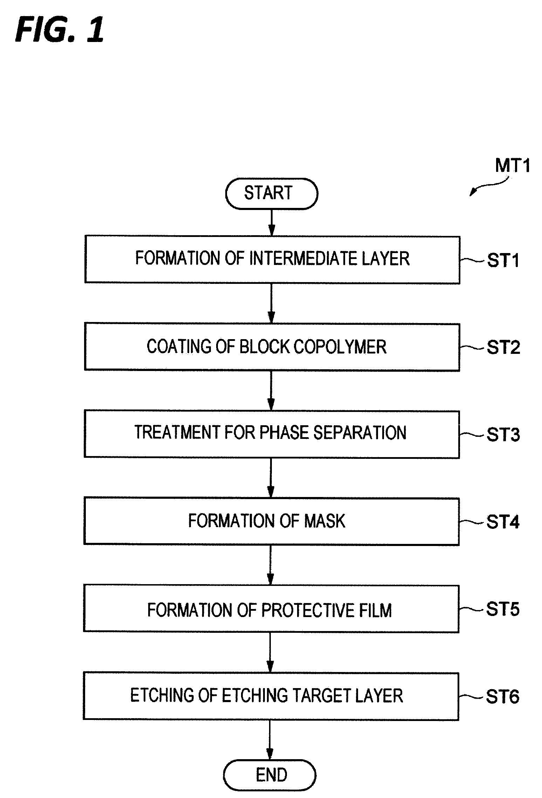

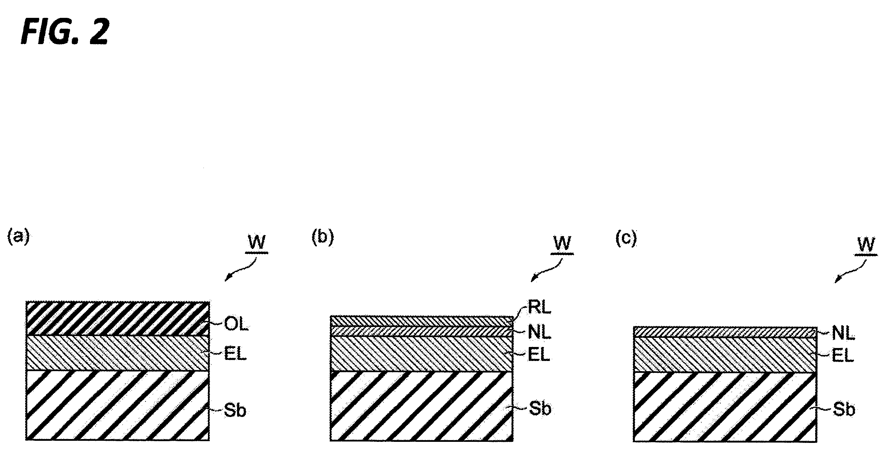

FIG. 1 is a flowchart illustrating an etching method according to an exemplary embodiment. FIG 2, FIG. 3, and FIG. 4 are views illustrating a cross-section of a product prepared in each step illustrated in FIG. 1. As illustrated in FIG. 1, etching method MT1 according to an exemplary embodiment includes step ST1, step ST2, step ST3, step ST4, step ST5, and step ST6. In method MT1, first of all, in step ST1, an intermediate layer NL is formed on a surface of a workpiece (hereinafter, referred to as a "wafer") W.

As illustrated in FIG. 2(a), the wafer W includes a substrate Sb and an etching target layer EL. The substrate Sb is made of, for example, silicon. The etching target layer EL is formed on the substrate Sb. The etching target layer EL is a silicon-containing layer. For example, the etching target layer EL may be a SiN layer, a silicon oxide layer, or a silicon-containing resist layer. Further, the etching target layer EL may have a film thickness of, for example, 15 nm to 20 nm.

As illustrated in FIG. 2(a), in step ST1, an organic film OL is coated on the etching target layer EL. The organic film OL is a block copolymer of, for example, styrene and methyl methacrylate. Subsequently, the wafer W is subjected to a heat treatment after the coating. The proper value of the heat treatment temperature depends on the kind of the organic film OL, but is usually about 200 °C to 300 °C. The heat treatment temperature is, for example, 250 °C. By the heat treatment, the organic film OL is generally reduced, and an intermediate layer NL and an altered layer RL are formed from the organic layer OL. Meanwhile, the altered layer RL is a layer in which carbon in the organic layer OL is altered.

Subsequently, as illustrated in FIG. 2(c), the altered layer RL is chemically removed by a development treatment. Therefore, the intermediate layer NL is formed on the etching target layer EL. The surface of the intermediate layer NL has a neutral state that is neither hydrophobic nor hydrophilic. Polymers in a block copolymer layer (to be described later) have a strong hydrophilicity if the polymer length is short, or strong hydrophobicity if the polymer length is long. Thus, since there are a strong hydrophilic type and a strong hydrophobic type in the polymers, the polymers may be phase-separated in a desired shape by forming the intermediate layer NL having a neutral surface.

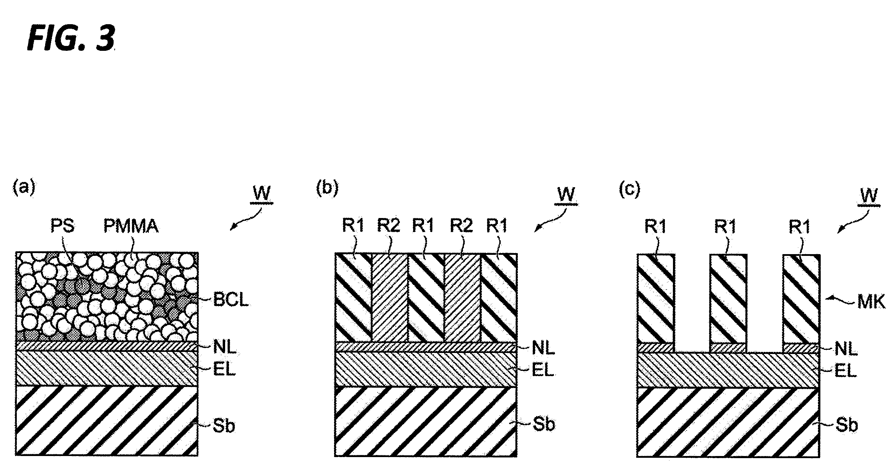

In method MT1, step ST2 is subsequently performed. In step ST2, a block copolymer is coated on the surface of the wafer W, that is, the surface of the intermediate layer NL. The block copolymer may be coated by various methods such as, for example, a spin coat method. Therefore, as illustrated in FIG. 3(a), a block copolymer layer BCL is formed on the surface of the intermediate layer NL.

The block copolymer is a self-assembled block copolymer, and includes a first polymer and a second polymer. In an exemplary embodiment, the block copolymer is polystyrene-block-poly(methyl methacrylate) (PS-b-PMMA). PS-b-PMMA includes polystyrene (PS) as the first polymer, and poly(methyl methacrylate) (PMMA) as the second polymer.

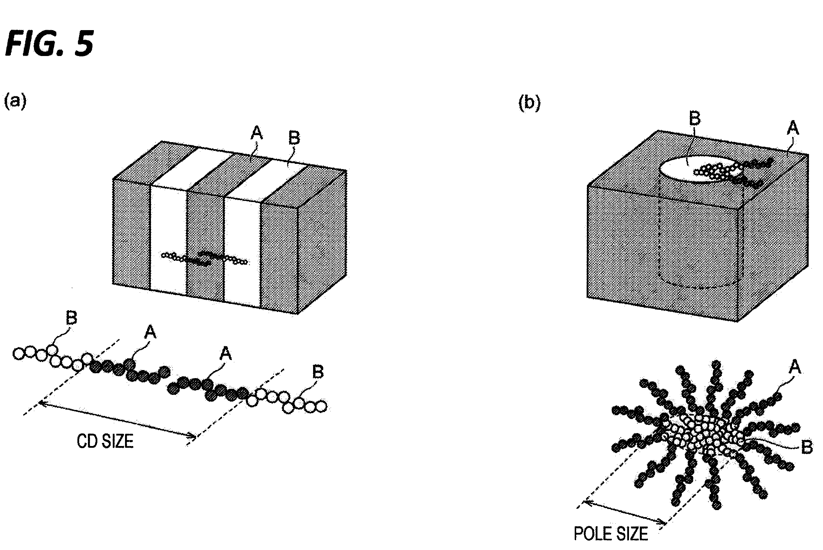

Here, the block copolymer and its self-assembly will be described using PS-b-PMMA by way of an example with reference to FIG. 5. Both of PS and PMMA are polymers in which one molecule has a diameter of 0.7 nm. When a block copolymer containing PS and PMMA, which are immiscible with each other, is coated on the intermediate layer NL to form the block copolymer layer BCL, and then, the wafer W is subjected to a heat treatment (annealing) at normal temperature (25 °C) to 300 °C or less, a phase separation occurs in the block copolymer layer BCL. On the contrary, if the heat treatment is performed at a temperature higher than 300 °C, the phase separation of the block copolymer layer BCL does not occurs, so that PS and PMMA are randomly arranged. Further, even though the temperature is returned to normal temperature after the phase separation, the block copolymer layer BCL is maintained in the phase-separated state.

When the polymer length of each polymer is short, the interaction (repulsive force) becomes weaker and the hydrophilicity becomes stronger. On the other hand, when the polymer length is long, the interaction (repulsive force) becomes stronger and the hydrophobicity becomes stronger. Using such a polymer property, a phase-separated structure of PS and PMMA may be prepared, for example, as illustrated in FIG. 5. FIG. 5(a) illustrates a phase-separated structure in which Polymer A and Polymer B have substantially the same polymer length. In the example, Polymer A is PS and Polymer B is PMMA. In the case illustrated in FIG. 5(a), the interaction of each polymer is the same. Thus, when the block copolymer layer BCL is subjected to a heat treatment at about 250 °C, Polymer A and Polymer B are self-assembled and phase-separated linearly. That is, Polymer A forms first linear regions, and Polymer B forms second linear regions, each of which is located between the first regions. For example, when the Polymer B-containing second regions are removed using the phase-separated structure, a periodic pattern of lines and spaces (L/S) may be formed. The periodic pattern may be applied as a pattern for manufacturing devices such as semiconductor devices.

Further, FIG. 5(b) illustrates a phase-separated structure in which Polymer A and Polymer B are considerably different in polymer length, that is, the polymer length of Polymer A is longer than the polymer length of Polymer B. In the case illustrated in FIG. 5(b), the interaction (repulsive force) of Polymer A is stronger, and the interaction (repulsive force) of Polymer B is weaker. When the block copolymer layer BCL is subjected to a heat treatment at about 250 °C, due to the difference in strength of the interaction between the polymers, Polymer A is self-assembled outward and Polymer B is self-assembled inward. That is, Polymer B is self-assembled in a cylindrical shape to thereby form a second region, and Polymer A is self-assembled to surround the cylindrical region, to thereby form a first region. For example, when the second region is removed using the phase-separated structure including the first region and the second region, a periodic pattern of holes may be formed. This periodic pattern may also be applied as a pattern for manufacturing devices such as semiconductor devices.

Reference is made back to FIG. 1. In step ST3 of method MT1, a treatment for the phase separation of the block copolymer layer BCL is performed. In step ST2 of an exemplary embodiment, the wafer W is heated at a temperature of 200 °C to 300 °C, so that phase separation occurs in the block copolymer layer BCL. By step ST3, as illustrated in FIG. 3(b), first regions R1 containing the first polymer and second regions R2 containing the second polymer are formed in the block copolymer layer BCL. As described above, the first regions R1 and the second regions R2 may be alternated to form a line pattern. Alternatively, the second region R2 may be a cylindrical region, and the first region R1 may surround the cylindrical second region R2.

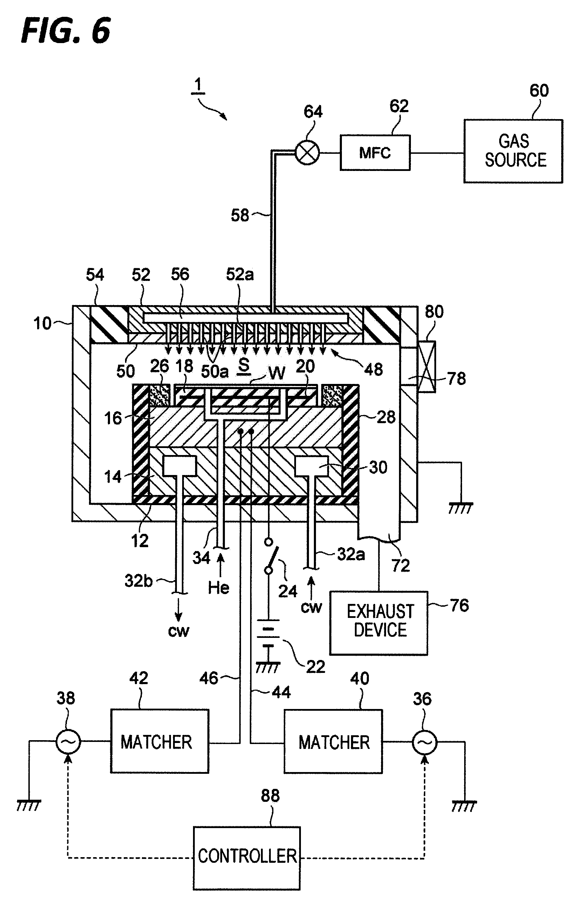

Prior to the subsequent step ST4, the wafer W is conveyed into a plasma processing apparatus. FIG. 6 is a view schematically illustrating an exemplary embodiment of a plasma processing apparatus which may be used for performing method MT1. The plasma processing apparatus 1 illustrated in FIG. 6 is a capacitively coupled parallel plate type plasma processing apparatus, and is provided with a substantially cylindrical chamber (processing container) 10. The chamber 10 is grounded. The inner surface of the chamber 10 is subjected to an anodizing treatment (anodic oxidation treatment). In addition, the chamber 10 is grounded.

In the bottom portion of the chamber 10, a cylindrical susceptor support 14 is disposed via an insulating plate 12 made of, for example, ceramic. A susceptor 16 made of, for example, aluminum is provided on the susceptor support 14.

On the top surface of the susceptor 16, an electrostatic chuck 18 is provided to hold the wafer W by electrostatic attraction force. The electrostatic chuck 18 has a structure where a chuck electrode 20 made of a conductive film is interposed between a pair of insulating layers or insulating sheets. The electrode 20 is electrically connected with a DC power source 22 via a switch 24. In the plasma processing apparatus 1, the wafer W is able to be attracted and held on the electrostatic chuck 19 by electrostatic attraction force generated by a DC voltage from the DC power source 22. A focus ring 26 is disposed around the electrostatic chuck 18 on the susceptor 16 to enhance in-plane uniformity of the etching. The focus ring 26 is made of, for example, silicon. Further, a cylindrical inner wall member 28 made of, for example, quartz is attached on the side of the susceptor 16 and the susceptor support 14.

A coolant chamber 30 is formed inside the susceptor support 14. The coolant chamber 30 extends, for example, annularly within the susceptor support 14. A coolant, for example, cooling water cw of a predetermined temperature is circulated and supplied from an external chiller unit to the coolant chamber through pipes 32a, 32b. In the plasma processing apparatus 1, the temperature of the wafer W on the susceptor 16 is controlled by controlling the temperature of the coolant cw. Further, a heat transfer gas such as, for example, helium (He) gas from a heat transfer gas supply mechanism (not illustrated) is supplied between the top surface of the electrostatic chuck 18 and the rear surface of the wafer W through a gas supply line 34.

Further, the susceptor 16 is electrically connected with a first high frequency power source 36 for plasma generation and a second high frequency power source 38 for ion attraction via matchers 40, 42 and power feeding rods 44, 46, respectively.

The first high frequency power source 36 generates a first frequency power of a frequency suitable for plasma generation, for example, 40 MHz. Further, the first frequency may be a frequency of 60 MHz or 100 MHz. Meanwhile, the second high frequency power source 38 generates a second frequency power of a relatively low frequency suitable for attracting ions of plasma to the wafer W on the susceptor 16, for example, 13 MHz.

An upper electrode 48 is provided above the susceptor 16 to face the susceptor in parallel. The upper electrode 48 is constituted by an electrode plate 50 and an electrode support 52 that detachably supports the electrode plate 50. The electrode plate 50 includes a plurality of gas holes 50a formed therein. The electrode plate 50 may be made of a semiconductor material such as, for example, Si or SiC. The electrode support 52 is made of, for example, aluminum, of which the surface is subjected to an anodizing treatment. The electrode plate 50 and the electrode support 52 are attached to an upper portion of the chamber 10 via a ring-shaped insulator 54. The ring-shaped insulator 54 is made of, for example, alumina. A plasma generating space, that is, a processing space S is defined between the upper electrode 48 and the susceptor 16.

A gas buffer chamber 56 is formed in the electrode support 52. In addition, the electrode support 52 includes a plurality of gas vent holes 52a formed to communicate the gas buffer chamber 56 and the gas holes 50a of the electrode plate 50. The gas buffer chamber 56 is connected with a gas source 60 through a gas supply pipe 58. The gas supply pipe 58 is provided with a mass flow controller (MFC) 62 and an opening/closing valve 64. When a processing gas is introduced into the gas buffer chamber 56 from the gas source 60, the processing gas is injected from the gas holes 50a of the electrode plate 50 toward the wafer W on the susceptor 16, in a shower form in the processing space S. As such, the upper electrode 48 also serves as a shower head configured to supply the processing gas to the processing space S.

An annular space formed between the susceptor 16 and the susceptor support 14, and the sidewall of the chamber 10 serves as an exhaust space. An exhaust port 72 of the chamber 10 is formed on the bottom of the exhaust space. The exhaust port 72 is connected with an exhaust device 76. The exhaust device 76 is provided with a vacuum pump such as, for example, a turbo molecular pump, and is configured to decompress the inside of the chamber, particularly, the processing space S to a desired degree of vacuum. Further, a gate valve 80 is attached to the sidewall of the chamber 10 to open/close a carry-in/out port 78 of the wafer W.

A controller 88 includes a central processing unit (CPU), a read only memory (ROM), and a random access memory (RAM), and the CPU controls the execution of the process, for example, according to various recipes stored in the RAM.

When the wafer W is processed in the plasma processing apparatus 1, the gate valve 80 is first opened, and the wafer W held on a conveyance arm is then carried into the chamber 10. Then, the wafer W is placed on the electrostatic chuck 18. After the carry-in of the wafer W, the gate valve 80 is closed, and the processing gas is introduced from the gas source 60 into the chamber 10 at a predetermined flow rate and in a predetermined flow rate ratio. Then, the pressure in the chamber 10 is decreased to a set value by the exhaust device 76. In addition, a high frequency power is supplied from the first high frequency power source 36 to the susceptor 16, and optionally, a high frequency bias power is also supplied from the second high frequency power source 38 to the susceptor 16. Thus, the processing gas introduced in a shower form from the shower head is excited to generate plasma. The wafer W is processed by active species such as radicals and ions in the plasma.

Reference is made back to FIG. 1. In step ST4 of method MT1, a mask is formed. Thus, using the plasma processing apparatus, the second region R2 of the block copolymer layer BCL and the intermediate layer NL just below the second region R2 are etched. When step ST4 is performed by the plasma processing apparatus 1, a processing gas is supplied from the gas source 60 into the chamber 10, and the pressure in the chamber 10 is decompressed to a set value by the exhaust device 76. Further, a high frequency power is supplied from the first high frequency power source 36 to the susceptor 16. Meanwhile, in step ST4, a high frequency bias power may be supplied from the second high frequency power source 38 to the susceptor 16 as necessary. Since the processing gas used in step ST4 is a processing gas for etching the second region R2 containing the second polymer and the intermediate layer NL just therebelow, oxygen may be contained. For example, the processing gas may contain O₂ gas. The processing gas may further contain a rare gas such as Ar gas, or an inert gas such as N₂ gas.

In step ST4, the block copolymer layer BCL composed of an organic material is etched from its surface by active species of the oxygen. Here, the etching rate of the second region R2 composed of the second polymer is higher than that of the first region R1 composed of the first polymer. Therefore, by step ST4, the second region R2 is selectively etched. Further, when the second region R2 is removed, a part of the exposed intermediate layer NL is etched. By step ST4, the wafer W comes to a state illustrated in FIG. 3(c). That is, a mask MK including the first region R1 and the intermediate layer just therebelow is formed.

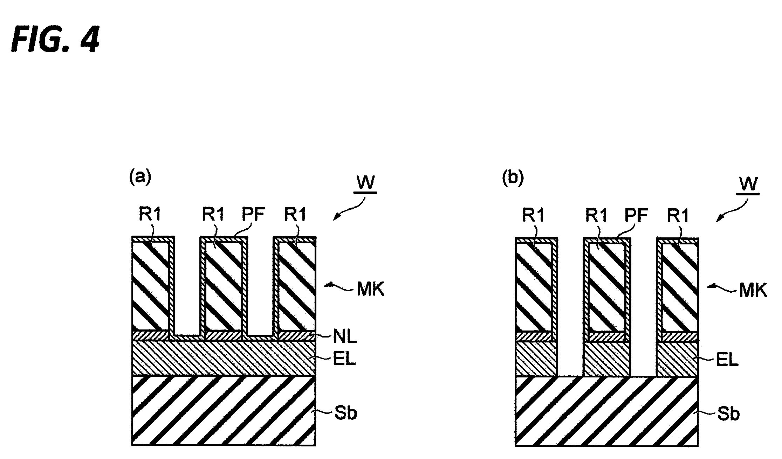

Subsequently, as illustrated in FIG. 1, in method MT1, step ST5 is performed. In step ST5, a protective film PF is formed on the mask MK. Thus, in step ST5, plasma of a processing gas containing silicon tetrachloride gas (SiCl₄) and oxygen gas (O₂) is generated within the plasma processing apparatus, and the wafer W is exposed to the plasma. Since the plasma contains active species of silicon and active species of oxygen, the protective film PF composed of silicon oxide is formed on the mask MK by step ST5, as illustrated in FIG. 4(a). Meanwhile, the processing gas used in step ST5 may further contain a rare gas such as Ar gas.

When step ST5 is performed by the plasma processing apparatus 1, the processing gas containing silicon tetrachloride gas and oxygen gas is supplied from the gas source 60 into the chamber 10, and the pressure in the chamber 10 is decompressed to a set value by the exhaust device 76. Further, a high frequency power is supplied from the first high frequency power source 36 to the susceptor 16. In step ST5, a high frequency bias power may be supplied from the second high frequency power source 38 to the susceptor 16 as necessary.

Subsequently, in method MT1, step ST6 is performed. In step ST6, an etching target layer EL exposed by the opening of the mask MK is etched. Thus, in step ST6, plasma of a processing gas containing fluorocarbon gas is generated within the plasma processing apparatus, and the wafer W is exposed to the plasma. Since the plasma contains active species of fluorine, the protective film PF on the etching target layer EL exposed by the opening of the mask MK, and the etching target layer EL just therebelow are etched by step ST6. By step ST6, the wafer W comes to a state illustrated in FIG. 4(b). That is, the pattern of the mask MK is transferred to the etching target layer EL. Meanwhile, the processing gas used in step ST6 may contain hydrofluorocarbon gas such as, for example, CHF₃, in addition to, or in place of the fluorocarbon gas. Further, the processing gas may further contain a rare gas such as, for example, Ar gas.

When step ST6 is performed by the plasma processing apparatus 1, the processing gas containing fluorocarbon gas is supplied from the gas source 60 into the chamber 10, and the pressure in the chamber 10 is decompressed to a set value by the exhaust device 76. Further, a high frequency power is supplied from the first high frequency power source 36 to the susceptor 16. In step ST6, a high frequency bias power may be supplied from the second high frequency power source 38 to the susceptor 16 as necessary.

In method MT1 described above, the protective film PF is formed on the mask MK prior to the etching of the etching target layer EL. By the protective film PF, the mask MK may be protected from the etching in step ST6. That is, it is possible to suppress deformation such as twisting of the mask MK due to the etching in step ST6.

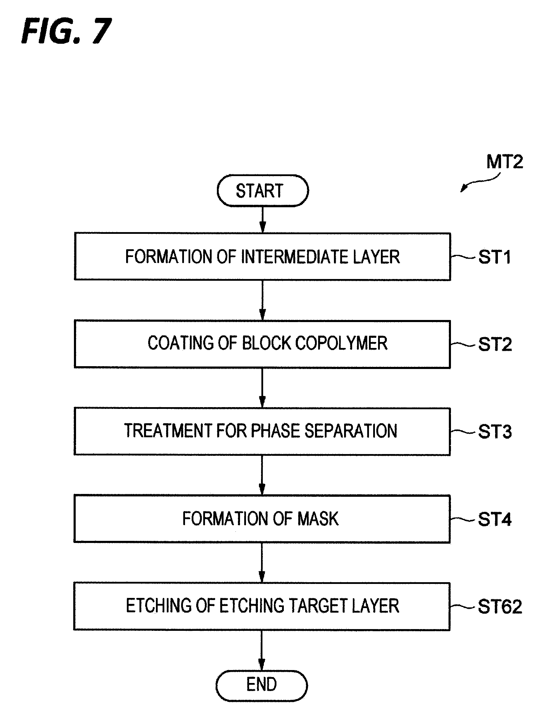

Hereinafter, an etching method according to another exemplary embodiment. FIG. 7 is a flowchart illustrating an etching method according to another exemplary embodiment. Method MT2 illustrated in FIG. 7 is different from MT1 in that step ST5 is not included, and step ST62 is included in place of step ST6. In step ST62, plasma of a gas containing at least one of fluorocarbon gas and fluorohydrocarbon gas, and hydrogen bromide gas, is generated within the processing container. The fluorocarbon gas is, for example, CF₄ gas, and the fluorohydrocarbon gas is, for example, CHF₃ gas.

In step ST62, the wafer W in a state after step ST4 is exposed to the generated plasma. In step ST62, a protective layer, which contains components such as SiBrO derived from active species of atoms or molecules contained in hydrogen bromide gas, is formed on the mask MK. Further, the mask is modified, that is, cured by the active species of Br. Further, since the plasma generated in step ST62 contains the active species of fluorine, the etching target layer EL is etched as in step ST6. Therefore, according to step ST62, the etching target layer EL may be etched while protecting the mask MK. Thus, according to step ST62, it is possible to suppress deformation such as twisting of the mask MK due to the etching.

As such, exemplary embodiments have been described, but without being limited thereto, various modifications may be available. For example, the plasma processing apparatus which may be used in steps ST4, ST5, ST6, and ST62 is not limited to the capacitively coupled plasma processing apparatus. In the steps, for example, an inductively coupled plasma processing apparatus, or a plasma processing apparatus using surface waves such as microwaves as a plasma source may be used.

### Description of Symbols

1: plasma processing apparatus
10: chamber
16: susceptor
18: electrostatic chuck
36: first high frequency power source
38: second high frequency power source
48: upper electrode
W: wafer
EL: etching target layer
NL: intermediate layer
BCL: block copolymer layer
R1: first region
R2: second region
MK: mask
PF: protective film

## Claims

1. A method of etching an etching target layer of a workpiece, the method comprising:
forming a self-assemblable block copolymer layer containing a first polymer and a second polymer on an intermediate layer formed on the etching target layer;
processing the workpiece to form a first region containing the first polymer and a second region containing the second polymer, from the block copolymer layer;
after the processing the workpiece, forming a mask by etching the second region and the intermediate layer just below the second region;
after the forming the mask, forming a protective film on the mask by generating plasma of a processing gas containing silicon tetrachloride gas and oxygen gas within a processing container of a plasma processing apparatus that accommodates the workpiece; and
after the forming the protective film, etching the etching target layer.

2. The method of claim 1, wherein the etching target layer is a silicon-containing layer, and
in the etching the etching target layer, plasma of a processing gas containing at least one of fluorocarbon gas and fluorohydrocarbon gas is generated within the processing container.

3. A method of etching an etching target layer of a workpiece, the method comprising:
forming a self-assemblable block copolymer layer containing a first polymer and a second polymer on an intermediate layer formed on the etching target layer;
processing the workpiece to form a first region containing the first polymer and a second region containing the second polymer, from the block copolymer layer;
after the processing the workpiece, forming a mask by etching the second region and the intermediate layer just below the second region;
after the forming the mask, etching the etching target layer,
wherein the etching target layer is a layer containing silicon oxide or silicon nitride, and
in the etching the etching target layer, plasma of a processing gas containing at least one of fluorocarbon gas and fluorohydrocarbon gas, and hydrogen bromide gas, is generated within the processing container.

4. The method of any one of claims 1 to 3, wherein the first polymer is polystyrene, and the second polymer is poly(methyl methacrylate).
